# EUROPEAN PATENT APPLICATION

(11) **EP 4 597 134 A1**
(43) Date of publication of application: **06.08.2025**
(21) Application number: 25155334.3
(22) Date of filing: 31.01.2025
(51) Int. Cl.: G01R 31/367, G01R 31/392

(54) **APPARATUS AND METHOD FOR DIAGNOSING BATTERY**

(30) Priority: 31.01.2024 KR 20240014967
(71) Applicant: LG Energy Solution, Ltd., Seoul 07335 (KR)
(72) Inventor: BAE, Yoon-Jung, 34122 Daejeon (KR); KIM, Ju-Ri, 34122 Daejeon (KR); KIM, Tae-In, 34122 Daejeon (KR); PAK, Seon-Ho, 34122 Daejeon (KR); SUN, Kyung-Eun, 34122 Daejeon (KR); JEONG, Hee-Seok, 34122 Daejeon (KR)
(74) Representative: Goddar, Heinz J.

(57) **Abstract**

The apparatus for diagnosing a battery according to the present disclosure includes a profile obtaining unit configured to obtain a battery profile representing a correspondence relationship between voltage and capacity of a battery; and a control unit configured to divide a capacity range of the battery profile into a plurality of sections, derive a target value for any one of one or more target indicators among a plurality of diagnostic indicators preset in each section, compare a correspondence relationship between the derived plurality of target values with one or more reference profile preset to represent a correspondence relationship between the plurality of target indicators, and diagnose a state of the battery based on the comparison result.

## Description

### TECHNICAL FIELD

This application is based on and claims priority from Korean Patent Application No. 10-2024-0014967, filed on January 31, 2024, with the Korean Intellectual Property Office, the disclosure of which is incorporated herein in its entirety by reference.

The present disclosure relates to an apparatus and method for diagnosing a battery, and more particularly, to an apparatus and method for diagnosing a battery, which diagnoses a state of a battery.

### BACKGROUND ART

Recently, the demand for portable electronic products such as notebook computers, video cameras and portable telephones has increased sharply, and electric vehicles, energy storage batteries, robots, satellites and the like have been developed in earnest. Accordingly, high-performance batteries allowing repeated charging and discharging are being actively studied.

Batteries commercially available at present include nickel-cadmium batteries, nickel hydrogen batteries, nickel-zinc batteries, lithium batteries and the like. Among them, the lithium batteries are in the limelight since they have almost no memory effect compared to nickel-based batteries and also have very low self-charging rate and high energy density.

Although much research is being conducted on these batteries in terms of high capacity and high density, improving lifespan and safety is also important. In order to improve battery safety, technology that accurately diagnoses the current state of the battery is required.

### DISCLOSURE

### Technical Problem

The present disclosure is designed to solve one or more of the problems of the related art. Therefore, some aspects of the present disclosure are directed to providing an apparatus and method for diagnosing a battery, which diagnoses a state of a battery and control the battery according to the diagnosis result. In the present disclosure, the battery may be a secondary battery and may also be denoted a rechargeable battery.

These and other objects and advantages of the present disclosure may be understood from the following detailed description and will become more fully apparent from the exemplary embodiments of the present disclosure. Also, it will be easily understood that the objects and advantages of the present disclosure may be realized by the means shown in the appended claims and combinations thereof.

### Technical Solution

An apparatus for diagnosing a battery according to a first aspect of the present disclosure may comprise a profile obtaining unit configured to obtain a battery profile representing a correspondence relationship between voltage and capacity of the battery; and a control unit configured to divide a capacity range of the battery profile into a plurality of sections, to derive a target value for any one of one or more target indicators among a plurality of diagnostic indicators preset in each section, to compare a correspondence relationship between the derived plurality of target values with one or more reference profiles preset to represent a correspondence relationship between the plurality of target indicators, and to diagnose a state of the battery based on the comparison result.

In this first aspect of the present disclosure, a battery profile representing a correspondence relationship between voltage and capacity of a battery is divided in two (or more) sections. One or more target indicators out of a plurality of different diagnostic indicators may be preset in each section. The target values representing the respective values of the target indicators in the sections may be determined for the individual sections using the battery profile. For example, the target values may be determined based on the battery profile or a differential profile obtained for the battery profile for individual sections thereof. In addition or alternatively, target values may be determined by measurement and may be associated with a section of the battery profile. A correspondence relationship between target values within the different sections may be determined and compared to a reference profile. The reference profile may be considered to indicate an expected or normal correspondence relationship (or reference relationship) between the target values. The combination of target values in a correspondence relationship may define a target point which can be compared to the reference profile.

For example, if the battery profile is divided into two sections, and each of the two sections has a preset target indicator, the target values of the respective target indicator in each of the two sections may be determined and combined in correspondence relationship which is compared to a corresponding reference profile. In another example, the battery profile may be divided into two sections, and each of the two sections has two preset target indicators. In this case, the target values of the respective two target indicators in each of the two sections may be determined. Thus, there may be two target values for the two target indicators for each section. In one example, one target value of a target indicator in the first section may be combined with one target value of a target indicator in the second section in a first correspondence relationship and is then compared to a corresponding first reference profile. Further, the other target value of the other target indicator in the first section may be combined with the other target value of the other target indicator in the second section in second correspondence relationship and is then compared to a corresponding second reference profile.

The control unit may be configured to diagnose the state of the battery as a positive/negative electrode degradation state when a target point representing the correspondence relationship between the plurality of target values is included in the reference profile. For example, when target point representing the correspondence relationship between the target values is included (or matches) the reference profile, the target values of the target point may correspond to the reference target values of the reference profile.
The control unit may be configured to diagnose the state of the battery as a negative electrode degradation state when the target point is included in a first region based on the reference profile.

The control unit may be configured to diagnose the state of the battery as a positive electrode degradation state when the target point is included in a second region based on the reference profile. The second region may be a region of the reference profile in which the second target value of the target point exceeds a reference second target value of the reference profile for the same first target value.

The control unit may be configured to diagnose the state of the battery as an EOL state when the target point is included in a third region.

The third region may be configured to be preset as a region that exceeds a preset threshold value for each of the plurality of target indicators. For example, the third region may be a region of the reference profile in which the first target value and the second target value of the target point exceed a first threshold of the first target value and second threshold for the second target value.

The control unit may be configured to reduce at least one of an upper limit C-rate and a constant voltage charge time set for the battery when the state of the battery is diagnosed as the positive electrode degradation state or the positive/negative electrode degradation state.

The control unit may be configured to reduce a charge upper limit voltage set for the battery when the state of the battery is diagnosed as the negative electrode degradation state or the positive/negative electrode degradation state.

The control unit may be configured to divide the capacity range into a first section and a second section based on a preset division ratio or target capacity.

The profile obtaining unit may be configured to obtain a differential profile corresponding to the battery profile.

The control unit may be configured to determine a main peak from the differential profile and divide the capacity range based on a capacity of the determined main peak.

The differential profile may be configured to represent a correspondence relationship between the capacity and a differential voltage of the battery. For example, the differential profile may be a profile in which the battery profile is differentiated with respect to the capacity. For example, when the battery profile is differentiated with respect to the capacity, the differential profile representing a correspondence relationship between the capacity and the differential voltage may be derived by the profile obtaining unit.

The control unit may be configured to determine a plurality of minimum points in the differential profile, and determine a minimum point with the smallest corresponding differential voltage as a main peak among the determined plurality of minimum points.

The differential profile may be configured to represent a correspondence relationship between the voltage and a differential capacity of the battery. For example, the differential profile may be a profile in which the battery profile is differentiated with respect to the voltage. For example, when the battery profile is differentiated with respect to the voltage, a second differential profile representing a correspondence relationship between the voltage and the differential capacity may be derived.

The control unit may be configured to determine a plurality of maximum points in the differential profile, and determine a maximum point with the largest corresponding differential voltage as a main peak among the determined plurality of maximum points.

A battery pack according to a second aspect of the present disclosure may comprise the apparatus for diagnosing a battery according to one of the embodiments of the first aspect of the present disclosure.

A vehicle according to a third aspect of the present disclosure may comprise the apparatus for diagnosing a battery according to one of the embodiments of the first aspect of the present disclosure.

A method for diagnosing a battery according to a fourth aspect of the present disclosure may comprise a profile obtaining step of obtaining a battery profile representing a correspondence relationship between voltage and capacity of a battery; a section dividing step of dividing a capacity range of the battery profile into a plurality of sections; a target value deriving step of deriving a target value for any one of one or more target indicators among a plurality of diagnostic indicators preset in each section; a comparing step of comparing a correspondence relationship between the derived plurality of target values with one or more reference profiles preset to represent a correspondence relationships between the plurality of target indicators; and a diagnosing step of diagnosing a state of the battery based on the comparison result.

The method may further comprise operations performed by the apparatus for diagnosing a battery according to one of the embodiments of the first aspect of the present disclosure.

One or more computer readable media according to a fifth aspect of the present disclosure may store instructions that, when executed by one or more processing units (e.g. provided in an apparatus for diagnosing a battery), cause the one or more processing units to diagnose a battery by executing comprise a profile obtaining step of obtaining a battery profile representing a correspondence relationship between voltage and capacity of a battery; a section dividing step of dividing a capacity range of the battery profile into a plurality of sections; a target value deriving step of deriving a target value for any one of one or more target indicators among a plurality of diagnostic indicators preset in each section; a comparing step of comparing a correspondence relationship between the derived plurality of target values with one or more reference profiles preset to represent a correspondence relationship between the plurality of target indicators; and a diagnosing step of diagnosing a state of the battery based on the comparison result.

The one or more computer readable media may further store instructions that, when executed by the one or more processing units, may cause the one or more processing units to perform the operations of the apparatus for diagnosing a battery according to one of the embodiments of the first aspect of the present disclosure.

A computer program according to a sixths aspect of the present disclosure, when executed by one or more processing units, cause the one or more processing units (e.g. provided in an apparatus for diagnosing a battery) to diagnose a battery by executing comprise a profile obtaining step of obtaining a battery profile representing a correspondence relationship between voltage and capacity of a battery; a section dividing step of dividing a capacity range of the battery profile into a plurality of sections; a target value deriving step of deriving a target value for any one of one or more target indicators among a plurality of diagnostic indicators preset in each section; a comparing step of comparing a correspondence relationship between the derived plurality of target values with one or more reference profiles preset to represent a correspondence relationship between the plurality of target indicators; and a diagnosing step of diagnosing a state of the battery based on the comparison result.

The computer program, when executed by the one or more processing units, may cause the one or more processing units to perform the operations of the apparatus for diagnosing a battery according to one of the embodiments of the first aspect of the present disclosure.

### Advantageous Effects

According to the first aspect of the present disclosure, there is an advantage in that the state of the battery may be diagnosed from various aspects depending on the combination of various target indicators.

In particular, since the target value for each section is a value representing the state of the battery corresponding to the section, the state of the battery may be more specifically separated and diagnosed based on the correspondence relationship of a plurality of target values.

The effects of the present disclosure are not limited to the effects mentioned above, and other effects not mentioned will be clearly understood by those skilled in the art from the description of the claims.

### DESCRIPTION OF DRAWINGS

The accompanying drawings illustrate a preferred embodiment of the present disclosure and together with the foregoing disclosure, serve to provide further understanding of the technical features of the present disclosure, and thus, the present disclosure is not construed as being limited to the drawing.
FIG. 1 is a diagram schematically showing an apparatus for diagnosing a battery according to an embodiment of the present disclosure.
FIG. 2 is a schematic drawing of a battery profile according to an embodiment of the present disclosure.
FIG. 3 is a schematic drawing of a plurality of target indicators according to an embodiment of the present disclosure.
FIG. 4 is a schematic drawing of a reference profile according to an embodiment of the present disclosure.
FIG. 5 is a schematic drawing of a differential profile according to an embodiment of the present disclosure.
FIG. 6 is a schematic drawing of a battery pack according to another embodiment of the present disclosure.
FIG. 7 is a drawing schematically showing a vehicle according to still another embodiment of the present disclosure.
FIG. 8 is a diagram schematically showing a method for diagnosing a battery according to still another embodiment of the present disclosure.

### DETAILED DESCRIPTION

It should be understood that the terms used in the specification and the appended claims should not be construed as limited to their general and dictionary meanings, but interpreted based on the meanings and concepts corresponding to technical aspects of the present disclosure on the basis of the principle that the inventor is allowed to define terms appropriately for the best explanation.

Therefore, the description proposed herein is just a preferable example for the purpose of illustrations only, not intended to limit the scope of the disclosure, so it should be understood that other equivalents and modifications could be made thereto without departing from the scope of the disclosure.

Additionally, in describing the present disclosure, when it is deemed that a detailed description of relevant known elements or functions renders the key subject matter of the present disclosure ambiguous, the detailed description is omitted herein.

The terms including the ordinal number such as "first", "second" and the like, may be used to distinguish one element from another element among various elements, but not intended to limit the elements by the terms.

Throughout the specification, when a portion is referred to as "comprising" or "including" any element, it means that the portion may include other elements further, without excluding other elements, unless specifically stated otherwise.

In addition, throughout the specification, when a portion is referred to as being "connected" to another portion, it is not limited to the case that they are "directly connected", but it also includes the case where they are "indirectly connected" with another element being interposed between them.

Hereinafter, a preferred embodiment of the present disclosure will be described in detail with reference to the accompanying drawings.

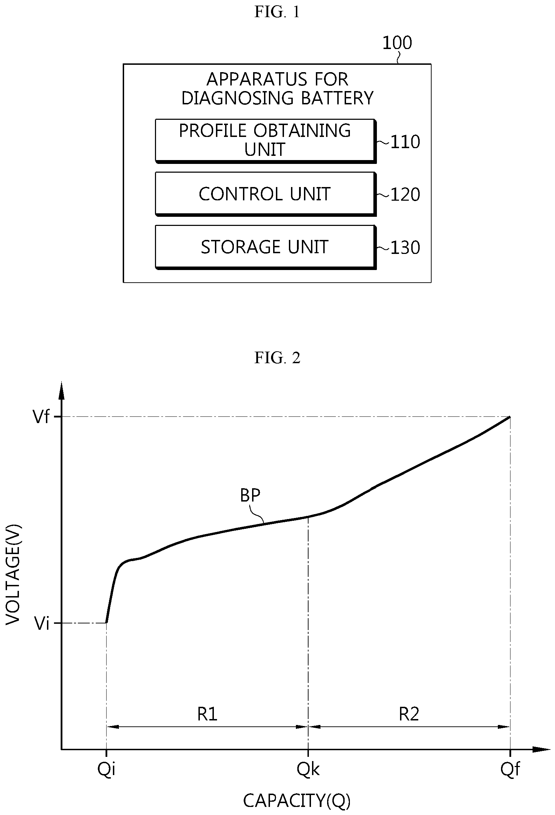

FIG. 1 is a diagram schematically illustrating an apparatus 100 for diagnosing a battery (also referred to as a diagnostic apparatus or device) according to an embodiment of the present disclosure.

Referring to FIG. 1, the apparatus 100 for diagnosing a battery may include a profile obtaining unit 110, a control unit 120, and a storage unit 130.

Here, the battery refers to one or more independent cells. The battery may have a negative terminal and a positive terminal. More specifically, each of the battery cells may be a physically separable unit. Each of the battery cells may have a negative terminal and a positive terminal. The negative terminals and positive terminals of the battery cells may be connected in series or in parallel to provide a negative terminal and positive terminal of the battery. A battery may be for example a lithium-ion battery or a lithium polymer battery. In addition, the battery may be of any type, such as for example a cylindrical battery type, a prismatic battery type or a pouch battery type. Additionally, the battery may also be a battery bank, a battery module or a battery pack in which a plurality of battery cells are connected in series and/or parallel. In the following description and for exemplary purposes only, the battery comprises one independent cell.

The profile obtaining unit 110 may be configured to obtain or receive a battery profile BP representing a correspondence relationship between voltage and capacity of the battery.

The battery profile BP may be, for example, a data structure that interrelates respective measurement values of the capacity Q of a battery to corresponding measurement values of the voltage V of the battery for the respective measurement values of the capacity Q (or vice versa). The battery profile BP may be determined in in a charging and/or discharging process of the battery. The battery profile BP may for example be or may be represented in a two-dimensional data array. In some embodiments, the battery profile BP may be representable as a two-dimensional profile, where one axis of the profile (e.g. the x-axis) denotes measurement values of the capacity Q of a battery, and another axis of the profile (e.g. the y-axis) denotes measurement values of the voltage V of the battery that correspond to the respective measurement values of the capacity Q of the battery. The number of pairs of measurement values of the capacity Q and corresponding measurement values of the voltage V in the battery profile BP may be determined by the number of measurements. Optionally, it is also possible to interpolate intermediate pairs of values of the capacity Q and corresponding values of the voltage V in the battery profile BP from the measured pairs of measurement values of the capacity Q and the corresponding voltage V in the battery profile BP.

Individual pairs of measurement values of the of the capacity Q and the corresponding voltage V of the battery may be obtained in a charging and/or discharging process of the battery. The individual pairs of measurement values of the of the capacity Q and corresponding measurement values of the of the voltage V of the battery may be obtained in a charging and/or discharging process of the battery in intervals, such as, for example, predetermined or configurable time intervals, predetermined or configurable changes of the capacity Q or predetermined or configurable changes of the state of charge (SOC) of the battery or state of health (SOH) of the battery. The measured voltage V may be a terminal voltage of the battery. The terminal voltage may be measured across the battery terminals while it is powering a load/discharging or during charging. In this case, the interval between measurements of a pair of capacity values Q and voltage values V may be a predetermined or configurable fixed interval. Alternatively, the measured voltage V may be an open circuit voltage (OCV). The OCV of the battery may be measured when no load is applied (i.e., the battery is at rest and not charging or discharging). In this case, the interval between measuring individual pairs of capacity Q and voltage V may be determined, for example, every time the battery is at rest for a predetermined amount of time (and not charging or discharging) so that transient effects on the measurements can be avoided or reduced. As noted above, if necessary, intermediate pairs of values of the capacity Q and corresponding values of the voltage V in the battery profile BP may be interpolated from the measured pairs of measurement values of the capacity Q and the corresponding voltage V in the battery profile BP so that the battery profile BP provides respective a respective pair of values of the capacity Q and voltage V at some predetermined or configurable "resolution" (e.g. in intervals of the capacity, e.g. a pair of values for every step (e.g. 1%, 2%, 3%, or 5%) of the capacity Q).

For example, the battery profile BP is a profile representing the correspondence relationship between voltage V and capacity Q when the capacity of the battery is charged from a preset charge start capacity (e.g. 0%, 5%, 10%, 15% or 20%) to a preset charge end capacity (e.g. 45%, 50%, 55%, 60%, 70%, 80%, 90% or 100%). As another example, the battery profile BP may represent the correspondence relationship between voltage V and capacity Q when the battery is discharged from the preset discharge start capacity (e.g. 45%, 50%, 55%, 60%, 70%, 80%, 90% or 100%) to the preset discharge end capacity (e.g. 0%, 5%, 10%, 15% or 20%).

In another example, the battery profile BP may be a profile representing the correspondence relationship between voltage V and capacity Q when the state of charge (SOC) of the battery is charged from a preset charge start SOC (e.g. 0%, 5%, 10%, 15% or 20%) to a preset charge end SOC (e.g. 45%, 50%, 55%, 60%, 70%, 80%, 90% or 100%). As another example, the battery profile BP may represent the correspondence relationship between voltage V and capacity Q when the state of charge of the battery is discharged from the preset discharge start SOC (e.g. 45%, 50%, 55%, 60%, 70%, 80%, 90% or 100%) to the preset discharge end SOC (e.g. 0%, 5%, 10%, 15% or 20%). The SoC may represent the remaining capacity of the battery as a percentage of its total charge capacity. Essentially, the SoC may thus indicate how "full" the battery is at a given moment. In another example, the battery profile BP is a profile representing the correspondence relationship between voltage V and capacity Q when the SOH of the battery is charged from a preset charge start SOC (e.g. 0%, 5%, 10%, 15% or 20%) to a preset charge end SOH (e.g. 45%, 50%, 55%, 60%, 70%, 80%, 90% or 100%). In yet another example, the battery profile BP may represent the correspondence relationship between voltage V and capacity Q when the state of charge of the battery is discharged from the preset discharge start state of health (SOH) (e.g. 45%, 50%, 55%, 60%, 70%, 80%, 90% or 100%) to the preset discharge end SOH (e.g. 0%, 5%, 10%, 15% or 20%). The SoH may represent the overall health or condition of a battery relative to its original, initial state (e.g. BOL (Beginning of Life) state). The SoH may thus reflect the battery's aging and degradation over time.

For example, when obtaining the battery profile M while charging or discharging the battery, there is no special limitation on the C-rate in charging or discharging for generating the battery profile BP. However, preferably, the battery should be charged or discharged at a low rate in order to obtain a more accurate battery profile BP and differential profile. For example, the battery profile BP may be generated in the process of charging or discharging the battery at 0.05 C.

For example, the profile obtaining unit 110 may directly obtain/receive the battery profile BP of the battery from the outside. That is, the profile obtaining unit 110 may obtain/receive the battery profile BP from an external device or unit. The external device or unit may be connected to the profile obtaining unit 110 via wire and/or wirelessly for receiving the battery profile BP. The external device or unit may be comprised by the apparatus 100 for diagnosing a battery or may be an external entity.

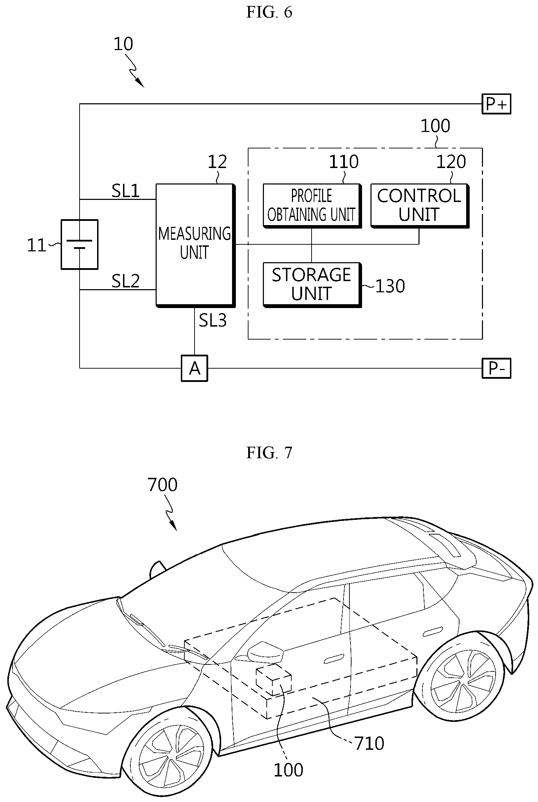

In some other embodiments, the profile obtaining unit 110 may be configured to generate the battery profile BP. For this, the profile obtaining unit 110 may receive the battery information about the voltage and capacity of the battery. In some embodiments, the profile obtaining unit 110 may be configured to control a measurement unit (for example, measuring unit 12, see FIG. 6). The measurement unit may be configured to measure pairs of measurement values of the capacity Q and the voltage V of the battery, and may provide the pairs of measurement values of the capacity Q and the voltage V of the battery as battery information to the profile obtaining unit 110 for generating the battery profile M. Then, the profile obtaining unit 110 may generate a battery profile BP based on the received battery information. That is, the profile obtaining unit 110 may obtain the battery profile BP by directly generating the battery profile BP based on the battery information.

The measurement unit may be comprised by the apparatus 100 for diagnosing a battery or may be an external entity. Further, in implementations, where the profile obtaining unit 110 obtains/receives the battery profile M from the outside from an external device or unit, the external device or unit may comprise the measurement unit.

FIG. 2 is a schematic drawing of a battery profile BP according to an embodiment of the present disclosure. In the embodiment of FIG. 2, the battery profile BP may be expressed as an X-Y graph in which the X-axis is set to capacity Q and the Y-axis is set to voltage V.

The profile obtaining unit 110 may be connected to communicate with the control unit 120. For example, the profile obtaining unit 110 may be connected to the control unit 120 by wire and/or wirelessly. The profile obtaining unit 110 may transmit the obtained battery profile BP to the control unit 120.

The control unit 120 may be configured to divide the capacity range of the battery profile BP along the X-axis (capacity axis) into a plurality of sections.

Specifically, the control unit 120 may divide the entire capacity range of the battery profile BP into two or more sections. The capacity range of the battery profile BP may also be denoted capacity section. The capacity range of the battery profile BP may be a range of capacity values in which the battery profile BP is defined. For example, in the embodiment of FIG. 2, the capacity range of the battery profile BP covers a range of capacities starting at the capacity Qi and ending at the capacity Qf. The control unit 120 may divide the capacity range from Qi to Qf into the first sub-section R1 and the second sub-section R2 based on a capacity Qk. The value of Qk may serve as the splitting point that divides the total capacity range of a battery (Qi to Qf) into smaller sub-sections for more granular analysis and diagnosis as outlined herein below. As such Qk may be considered a reference point to simplify and enhance the accuracy of battery diagnostics by enabling localized analysis of the battery profile BP.

The control unit 120 may be configured to determine or derive a target value for any one of one or more target indicators among a plurality of diagnostic indicators preset in each section. For example, considering FIG. 2, the control unit 120 may determine or derive a respective target value for each target indicator set for a respective one of the sections R1 and R2 and for each of sections R1 and R2.

Specifically, one or more diagnostic indicators may be preset as one or more target indictors for each of the plurality of sections. Here, a diagnostic indicator may be an indicator representing the state of the battery in the corresponding section and may be used to diagnose the state of the battery in the corresponding section. For example, since there are unique indicators that can only be derived from one, some or all of the plurality of sections, some or all of the diagnostic indicators set as target indicators for each of the plurality of sections may be different.

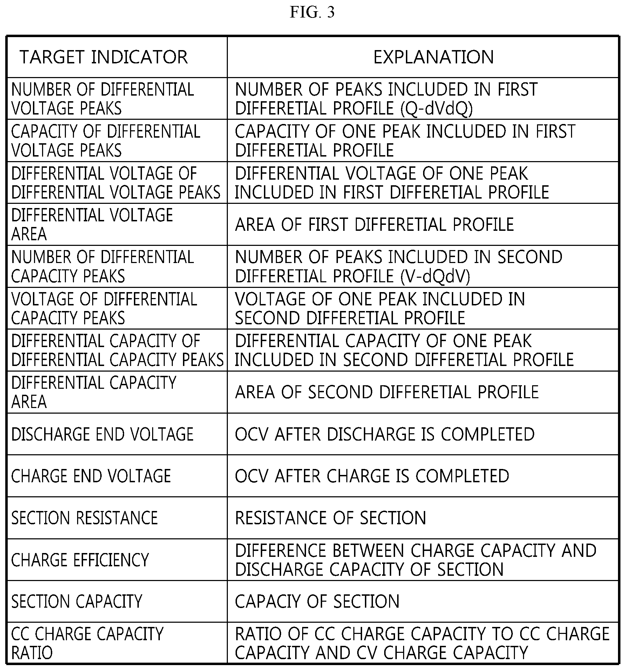

FIG. 3 is a schematic drawing of a plurality of target indicators according to an embodiment of the present disclosure. Some of the target indicators may be derived from a first differential profile or a second differential profile.

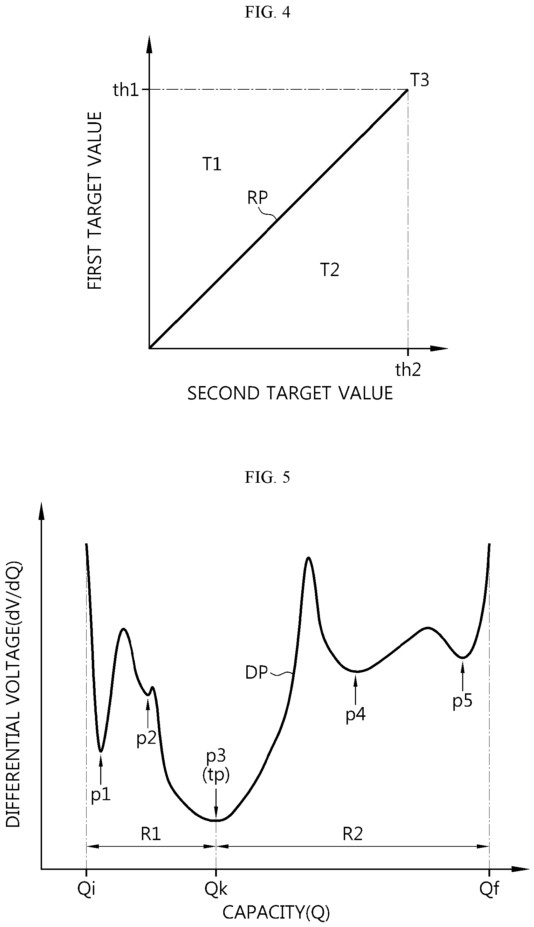

A first differential profile may be a profile in which the battery profile BP is differentiated with respect to the capacity. For example, when the battery profile BP is differentiated with respect to the capacity, a first differential profile representing a correspondence relationship between the capacity Q and the differential voltage dV/dQ may be derived. An example of a first differential profile is shown in FIG. 5. The first differential profile of the battery profile BP may include two sections R1 and R2. The first differential profile may also be considered to include two first differential profiles that correspond to the sections R1 and R2, respectively. The first differential profile in FIG. 5 may be based on the battery profile BP in FIG. 2. In this case, the two (sub-)sections R1 and R2 in FIG. 5 may correspond to the two (sub-)sections R1 and R2 in FIG. 2, but this is not mandatory. In the following, the corresponding section mentioned in connection with a first differential profile may thus correspond to a capacity sub-section (such as for example R1 and R2 in FIG. 2 and FIG. 5) for which the target indicator is determined.

A second differential profile may be a profile in which the battery profile BP is differentiated with respect to the voltage. For example, when the battery profile BP is differentiated with respect to the voltage, a second differential profile representing a correspondence relationship between the voltage V and the differential capacity dQ/dV may be derived. In some embodiments, the battery profile BP in each of the sections of the capacity range is differentiated separately with respect to voltage forming plural second differential profiles (e.g. for each of sections R1 and R2 as shown in FIG. 2). A respective second differential profile for the corresponding section represents a correspondence relationship between the capacity Q and the differential voltage dV/dQ in the respective corresponding section (e.g. either section R1 or section R2 in FIG. 2). In this case, each second differential profile may be associated with a respective voltage section. The voltage section may be defined as a range between the minimum and maximum voltage values Vi and Vf in the corresponding section or may cover a predetermined voltage range (e.g. from 0V to 4V). Alternatively, in some embodiments, the voltage section between the minimum voltage Vi and maximum voltage Vf of the battery profile BP may be divided into sub-sections, e.g. using a voltage value Vk that defines the splitting point of the voltage section. In this case, a second differential profile representing a correspondence relationship between the voltage V and the differential capacity dQ/dV may be derived for each of the voltage sub-sections, similar to the first differential profile. In the following, the corresponding section mentioned in connection with a second differential profile may be a capacity sub-section or a voltage sub-section in accordance with the two alternatives described above for which the respective target indicator is determined.

In the following, different types of target indicators or diagnostic indicators are described:
(1) The number of differential voltage peaks is the number of peaks included in a corresponding section of the first differential profile. For example, the number of maximum points and/or minimum points of the differential voltage (dV/dQ) included in the corresponding section of the first differential profile may be determined as the number of differential voltage peaks. In the first differential profile of FIG. 5, a number of differential voltage peaks may be determined for each of the sections R1 and R2.
   Here, the differential voltage peak means a peak included in the first differential profile. Further, the first differential profile may include a plurality of differential voltage peaks. Here, the differential voltage peak means a maximum point and/or a minimum point included in the first differential profile.
(2) The capacity of the differential voltage peak is the capacity of a target peak included in the corresponding section of the first differential profile. For example, the peak with the largest corresponding differential voltage among one or more maximum points included in the corresponding section of the first differential profile may be determined as the target peak. The target peak may be changed depending on the state of the battery to be diagnosed.
(3) The differential voltage of the differential voltage peak is the differential voltage of the target peak included in the corresponding section of the first differential profile.
(4) The differential voltage area is an area of the corresponding section of the first differential profile. The differential voltage area may be, for example, the integral of the differential voltage (dV/dQ) across capacity values Q of the corresponding section. The differential voltage values of the corresponding section of the first differential profile integrated with respect to the capacity may be determined as the differential voltage area.
(5) The number of differential capacity peaks is the number of peaks included in the corresponding section of the second differential profile. For example, the number of maximum points and/or minimum points of the differential capacity (dQ/dV) included in the corresponding section of the second differential profile may be determined as the number of differential capacity peaks.
   Here, the differential capacity peak means a peak included in the second differential profile. In addition, the second differential profile may include a plurality of differential capacity peaks. Here, the differential capacity peak means a maximum point and/or a minimum point included in the second differential profile.
(6) The capacity of the differential capacity peak is the capacity of a target peak included in a corresponding section of the second differential profile. For example, the peak with the largest corresponding differential capacity among one or more maximum points included in the corresponding section of the second differential profile may be determined as the target peak. The target peak may be changed depending on the state of the battery to be diagnosed.
(7) The differential capacity of the differential capacity peak is the differential capacity of the target peak included in the corresponding section of the second differential profile.
(8) The differential capacity area is the area of the corresponding section of the second differential profile. The differential capacity area may be, for example, the integral of the differential capacity (dQ/dV) across voltage values V of the corresponding section. The integrated differential capacity values of the corresponding section of the second differential profile with respect to voltage may be determined as the differential capacity area.
(9) The discharge end voltage refers to the OCV (open circuit voltage) after the discharge of the battery is completed. Since the discharge end voltage may be derived when the discharge of the battery is completed, it is a diagnostic indicator that may be derived only in the low-capacity section (e.g. R1) of the battery profile BP. Specifically, the discharge end voltage may be derived in the low-capacity section corresponding to the voltage set to terminate the discharge of the battery. Put different, the discharge end voltage can be determined within the low-capacity range of the battery profile BP, corresponding to the voltage level at which the battery's discharge process is terminated.
(10) The charge end voltage refers to the OCV after the charge of the battery is terminated. Since the charge end voltage may be derived when the charge of the battery is terminated, it is a diagnostic indicator that may be derived only in the high-capacity section (e.g. R2) of the battery profile BP. Specifically, the charge end voltage may be derived in the high-capacity section corresponding to the voltage set to terminate the charge of the battery. Put different, the charge end voltage can be determined within the high-capacity range of the battery profile BP, corresponding to the voltage level at which the battery's charge process is terminated.
(11) The section resistance means the ratio of voltage change amount to the charge/discharge current of the corresponding section of the battery profile BP. For example, a section resistance may be determined for each of sections R1 and R2. The section resistance may quantify the effective resistance of the battery within a corresponding section of its charge or discharge process. As such, the section resistance may reflect the degree to which the battery resists the flow of electric current and is a measure of how much the battery's voltage changes in response to the applied current over the corresponding section. For example, the resistance may be calculated as the ratio of the change in voltage to the applied current within the capacity range that defines the corresponding section.
(12) The charge efficiency means the difference between the charge capacity and the discharge capacity. For example, the charge efficiency of the low-capacity section in the nth cycle may be calculated according to the formula of "charge capacity of the nth cycle minus discharge capacity of the nth cycle." Further, the charge efficiency of the high-capacity section in the nth cycle may be calculated according to the formula of "discharge capacity of the nth cycle minus charge capacity of the n+1th cycle." In other words, the charge efficiency is not limited to the corresponding section, but may be calculated according to the entire charge/discharge capacity of the cycle.
(13) The section capacity refers to the capacity of the section. The section capacity may refer to the amount of capacity (usually measured in ampere-hours, Ah, or milliampere-hours, mAh) contained within a specific section (e.g. R1 and R2) of the battery's capacity range. The section capacity may thus be defined as the difference in capacity between the start and end points of the respective section.
(14) The CC charge capacity ratio refers to the ratio of the CC charge capacity to the CC (constant current) charge capacity and the CV (constant voltage) charge capacity. Since the CV charge is performed at the end of the charge, the CC charge capacity ratio is a diagnostic indicator that may be derived only in the high-capacity section. Specifically, the CC charge capacity ratio may be derived in the high-capacity section corresponding to the voltage set to terminate the charge of the battery.

The control unit 120 may be configured to compare the correspondence relationship between the derived plurality of target values with one or more preset reference profiles RP representing the correspondence relationship between the plurality of target indicators.

The control unit 120 may be configured to compare the correspondence relationship between target values of the target indicators determined for the sections (e.g. sections R1 and R2) of the battery profile BP with a preset reference profile RP representing the correspondence relationship (or reference relationship) between reference target values of the target indicators for the sections (e.g. sections R1 and R2) of the battery profile BP.

The type of the target indicator of one section may be the same as the type of a target indicator of another section. Alternatively, the type of the target indicator of one section may be different from the type of a target indicator of another section. Hence, the correspondence relationship between target values may be a correspondence relationship between target values of the same type of target indicator set for the sections of the battery profile BP or between target values of different types of target indicators set for the sections of the battery profile BP.

The comparison of the correspondence relationship between the derived target values for the given target indicator with a preset reference profile RP for the given target indicator may be for example performed for each (type of) target indicator that has been set for or that is associated with the sections of the battery profile BP. A respective reference profile RP may be associated with one type of target indicators or a given combination of different types of target indicators. For example, considering that the battery profile BP is divided into two sections R1 and R2, the reference profile RP may indicate how a first target value determined for the first section R1 is expected to change in relation to the second target value determined for the second section R2 (or vice versa). In general, the reference profile RP may indicate how one or more target values determined for the one or more sections of the battery profile BP is/are expected to change in relation to another target value determined for another section of the batter profile BP. A target value may be considered referring to the current value determined based on a current (most recent) battery profile BP for one of the target indicators of a respective section (e.g. R1 or R2) of the battery profile BP.

Specifically, in one embodiment, it may be assumed that the capacity range of the battery profile BP is divided into the first section R1 and the second section R2, the first target value for the target indicator is derived from the first section R1, and the second target value for the target indicator is derived from the second section R2.

The control unit 120 may compare a target point representing the correspondence relationship of the plurality of target values with the reference profile. A target point may be thus considered target point representing the correspondence relationship of the plurality of target values of a given target indicator. A target point may thus be considered a combination of target values of a specific target indicator that have been determined for the different sections of the battery profile BP, such as sections R1 and R2 in FIG. 2 and FIG. 5.

In some embodiments, the target point may be considered a coordinate point in a X-Y graph in which the X-axis is set to the second target value and the Y-axis is set to the first target value. As such, the target point may be considered a specific data point that summarizes diagnostic information about the battery by combining target values of a target indicator from the different sections of the battery profile BP.

FIG. 4 is a schematic drawing of a reference profile RP according to an embodiment of the present disclosure. In the embodiment of FIG. 4, the reference profile RP may be expressed as an X-Y graph in which the X-axis is set to the second target value and the Y-axis is set to the first target value. The first target value may be a target value of a target indicator for a first section (e.g. R1) of the capacity range of the battery profile BP and the second target value may be a target value of a different or the same target indicator for a second section (e.g. R2) of the capacity range of the battery profile BP. The target point may thus act as a summary diagnostic feature of the battery by combining the values of the target indicator(s) corresponding to the different sections of the capacity range of the battery profile BP. The target point may be compared to the reference profile RP, which represents an expected or normal correspondence relationship (or reference relationship) between the target values of the target indicator(s) for the different sections of the capacity range of the battery profile BP. This comparison may be used to determine whether the battery is in a healthy state or has undergone specific types of degradation.

Specifically, the control unit 120 may determine whether the target point is included in or matching the reference profile RP. In the example reference profile RP in FIG. 4, the expected or normal correspondence relationship (or reference relationship) between the first target value for section R1 and the second target value for section R2 of a given target indicator determined based on the battery profile BP forms a curve, which is a straight line in this example. To determine whether the target point is included in or matching the reference profile RP, the control unit 120 may determine whether the target point is lying on the curve (here: the straight line) of the reference profile RP or not. If the target point is not included in the reference profile RP, the control unit 120 may determine which region among the first region T1, the second region T2, and the third region T3 the target point is in.

Here, the first region T 1 is a region in which the first target value is greater than an expected first target value that is based on the reference profile RP. For example, in the embodiment of FIG. 4, the first region T1 is a region in which the first target value of the target point exceeds an expected first target value of the reference profile RP for the same second target value.

Here, the second region T2 is a region in which the second target value is greater than an expected second target value that is based on the reference profile. For example, in the embodiment of FIG. 4, the second region T2 is a region in which the second target value of the target point exceeds the expected second target value of the reference profile for the same first target value.

Here, the third region T3 may be configured to be preset as a region that exceeds a threshold value preset for each of the plurality of target indicators. A respective threshold value may be independently set for each of the first target value and the second target value. For example, in the embodiment of FIG. 4, the third region T3 is a region in which the first target value of the target point exceeds the first threshold value (th 1) and the second target value of the target point exceeds the second threshold value (th2).That is, in the embodiment of FIG. 4, the target point may be included in the reference profile, the first region T1, the second region T2, or the third region T3.

The control unit 120 may be configured to diagnose the state of the battery based on the comparison result. The control unit 120 may thus be configured to diagnose the state of the battery based on whether the target point is included in the reference profile. If the target point is not included in the reference profile, the control unit 120 may be configured to diagnose the state of the battery based on whether the target point is in the first region T1, the second region T2, or the third region T3.

For example, the control unit 120 may be configured to diagnose the state of the battery as a positive/negative electrode degradation state if the target point representing the correspondence relationship between the plurality of target values is included in the reference profile. Here, the positive/negative electrode degradation state is a state in which both the positive electrode and the negative electrode of the battery are degraded, and is a state in which the degradation degrees of the positive electrode and the negative electrode are balanced.

As another example, the control unit 120 may be configured to diagnose the state of the battery as a negative electrode degradation state if the target point is included in the first region T1 relative to the reference profile. Here, the negative electrode degradation state is a state in which the degradation of the negative electrode of the battery is more dominant than the degradation of the positive electrode. In other words, the negative electrode degradation state is a state in which the degradation of the positive electrode and the negative electrode are not balanced, and the degradation of the negative electrode progresses more than the degradation of the positive electrode. For example, the negative electrode degradation state is related to the loss of available lithium. When available lithium is lost, lithium plating, in which lithium metal is deposited on the surface of the negative electrode, may occur.

As another example, the control unit 120 may be configured to diagnose the state of the battery as a positive electrode degradation state if the target point is included in the second region T2 relative to the reference profile. Here, the positive electrode degradation state is a state in which the positive electrode of the battery is degraded, and the degradation of the positive electrode is more dominant than the degradation of the negative electrode. In other words, the positive electrode degradation state is a state in which the degradation of the positive electrode and the negative electrode are not balanced, and the degradation of the positive electrode progresses more than the degradation of the negative electrode.

As still another example, the control unit 120 may be configured to diagnose the state of the battery as an EOL (end of life) state if the target point is included in the third region T3. Here, the EOL state means a state in which the battery is significantly degraded and use of the battery is not recommended. For example, the EOL state may be a state in which the battery may be determined to be an unusable state.

If there are multiple target points that are compared to respective ones of corresponding reference profiles, the control unit 120 may be configured to diagnose the state of the battery based on each of the target points and may select the diagnose the state of the battery to correspond to the "worst case" diagnosis. For example, if one target point is in the corresponding reference profile, but another target point is not located in the corresponding reference profile but is in an of region T1, region T2 or region T3, the control unit 120 may be configured to diagnose the state of the battery based on said other target point. If some or all of the target points are not included in their respective reference profiles, the target points may likely show a similar deviation from the reference profiles, i.e. may likely be in the same region T1, region T2 or region T3, so that the control unit 120 may be configured to diagnose the state of the battery accordingly. If the target points may show a dissimilar deviation from the reference profiles, the deviation may likely be such that one or more target points are either in region T1 or region T2 and/or in the reference profile, and one or more target points are in region T3. In this case, the control unit 120 may be configured to diagnose the state of the battery based on the one or more target points in region T3.

The apparatus 100 for diagnosing a battery according to an embodiment of the present disclosure may diagnose the state of the battery according to the correspondence relationship of the one or more target values determined or calculated from each of the plurality of sections. That is, according to an embodiment of the present disclosure, there is an advantage in that the state of the battery may be diagnosed from various aspects according to the combination of various target indicators.

In particular, since a target value for each section is a value representing the state of the battery corresponding to the section, the state of the battery may be more specifically distinguished and diagnosed based on the correspondence relationship of the plurality of target values.

Meanwhile, the profile obtaining unit 110 and the control unit 120 included in the apparatus 100 for diagnosing a battery may optionally include processors, application-specific integrated circuits (ASICs), other chipsets, logic circuits, registers, communication modems, data processing devices, etc. known in the art to execute various control logics performed in the present disclosure. Also, when the control logic is implemented as software, the profile obtaining unit 110 and the control unit 120 may be implemented as a set of program modules. At this time, the program module may be stored in the memory and executed by the profile obtaining unit 110 and the control unit 120. The memory may be inside or outside the profile obtaining unit 110 and the control unit 120 and may be connected to the profile obtaining unit 110 and the control unit 120 by various well-known means.

In addition, the apparatus 100 for diagnosing a battery may further include a storage unit 130. The storage unit 130 may store data and/or instructions and/or a computer program necessary for implementation, operation and/or function of each component of the apparatus 100 for diagnosing a battery, data generated in the process of performing the operation or function, or the like. The storage unit 130 is not particularly limited in its kind as long as it is a known information storage means that can record, erase, update and read data. As an example, the information storage means may include RAM, flash memory, ROM, EEPROM, registers, and the like. In addition, the storage unit 130 may store program codes in which processes executable by the profile obtaining unit 110 and the control unit 120 are defined.

For example, the storage unit 130 may store the battery information, the battery profile BP, the differential profile, and the battery diagnosis information by the control unit 120.

The control unit 120 may be configured to control the battery based on the diagnosis result regarding the state of the battery. Specifically, the control unit 120 may change the usage conditions of the battery based on the diagnosis result.

The control unit 120 may be configured to reduce at least one of an upper limit C-rate and a constant voltage charge time set for the battery when the state of the battery is diagnosed as a positive electrode degradation state or a positive/negative electrode degradation state. That is, when the control unit 120 diagnoses that the positive electrode of the battery is degraded, the control unit 120 may change the usage conditions of the battery to prevent the positive electrode of the battery from being further degraded.

The control unit 120 may be configured to reduce the charge upper limit voltage set for the battery when the state of the battery is diagnosed as a negative electrode degradation state or a positive/negative electrode degradation state. When the control unit 120 diagnoses that the negative electrode of the battery is degraded, the control unit 120 may change the usage conditions of the battery to prevent the negative electrode of the battery from being further degraded.

As the usage conditions of the battery change, the deterioration of the positive electrode and/or negative electrode of the battery may be slowed, thereby increasing the expected life of the battery.

The control unit 120 may be configured to divide the capacity range into a first section R1 and a second section R2 based on a preset division ratio or target capacity. Please note that the present disclosure is not limited to dividing the capacity range of the battery profile in two sections, but the battery profile may also be divided into three, four or more sections. In this case, the reference profile and target point may include more than two dimensions, i.e. three, four or more dimensions.

In one embodiment, the control unit 120 may divide the capacity range based on a preset ratio. For example, the control unit 120 may divide the capacity range in a ratio of n: m (where n and m are positive numbers) to set the lower capacity range as the first section R1 and set the upper capacity range as the second section R2.

For example, assume that the start capacity is Qi and the end capacity is Qf. In addition, assume that the capacity corresponding to the ratio of n:m is Qk, and Qk may be calculated according to the formula: *Qk =* (*Qf* - *Qi*) ÷ (*n* + *m*) × *n.* The control unit 120 may set the capacity range of Qi to Qk as the first section R1. Further, the control unit 120 may set the capacity range of Qk to Qf as the second section R2.

In another embodiment, the control unit 120 may distinguish the capacity range using the differential profile based on the battery profile BP.

The profile obtaining unit 110 may be configured to further obtain a differential profile (such as the first differential profile and the second differential profile) corresponding to or based on the battery profile.

For example, when the battery profile BP is differentiated with respect to the capacity, a differential profile may be generated that represents the correspondence relationship between the differential voltage dV/dQ and the capacity Q. Conversely, when the battery profile BP is differentiated with respect to the voltage, a differential profile may be generated that represents the correspondence relationship between the differential capacity dQ/dV and the voltage V.

For example, the profile obtaining unit 110 may obtain or receive the differential profile of the battery from the outside. That is, the profile obtaining unit 110 may obtain/receive the differential profile from an external device or unit. The external device or unit may be connected to the profile obtaining unit 110 by wire and/or wirelessly and receiving the differential profile. The external device or unit may be comprised by the apparatus 100 for diagnosing a battery or may be an external entity.

In some other embodiments, the profile obtaining unit 110 may be configured to generate the battery profile BP. For this, the profile obtaining unit 110 may directly receive the battery profile BP of the battery from the outside. In some embodiments, the profile obtaining unit 110 may be configured to control a measurement unit (for example, measuring unit 12, see FIG. 6). The measurement unit may be configured to measure pairs of measurement values of the capacity Q and the voltage V of the battery, and may provide the pairs of measurement values of the capacity Q and the voltage V of the battery as battery information to the profile obtaining unit 110 for generating the battery profile BP. Then, the profile obtaining unit 110 may generate one or more differential profiles (such as the first differential profile and the second differential profile) based on the battery profile BP.

In one example, the profile obtaining unit 110 may obtain or receive a differential profile by receiving the battery profile BP through a wired and/or wireless connection to the external device or unit, and generating one or more differential profiles (such as the first differential profile and the second differential profile) from the received/obtained battery profile BP.

In another example, the profile obtaining unit 110 may receive battery information about the voltage and capacity of the battery. In this case, the profile obtaining unit 110 may generate a battery profile BP based on the received battery information, and generate one or more differential profiles (such as the first differential profile and the second differential profile) based on the generated battery profile BP. Hence, the profile obtaining unit 110 may obtain one or more differential profiles (such as the first differential profile and the second differential profile) by directly generating the differential profile based on the battery information.

The profile obtaining unit 110 may be connected to communicate with the control unit 120. For example, the profile obtaining unit 110 may be connected to the control unit 120 by wire and/or wirelessly. The profile obtaining unit 110 may transmit the obtained battery profile BP and/or the one or more differential profiles DP(s) to the control unit 120.

In one embodiment, the one or more differential profiles DP(s) obtained by the profile obtaining unit 110 may be configured to represent a correspondence relationship between the capacity Q and the differential voltage dV/dQ of the battery.

FIG. 5 is a schematic drawing of a differential profile DP according to an embodiment of the present disclosure. In the embodiment of FIG. 5, the differential profile DP may be expressed as an X-Y graph in which the X-axis is set to capacity Q and the Y-axis is set to differential voltage dV/dQ. The differential profile DP in FIG. 5 may be determined based on the battery profile BP in FIG. 2.

The control unit 120 may be configured to determine the main peak (tp) in the differential profile DP. For example, the main peak (tp) may correspond to the minimum differential voltage (dV/dQ) value in the differential profile DP. The main peak (tp) may also correspond to the absolute/global minimum of the of the differential profile DP.

In some embodiments, the control unit 120 may be configured to differentiate the differential profile DP with respect to voltage and to identify the main peak (tp) in the differentiated differential profile DP. The differentiated differential profile DP may be equivalent to a second derivative of the battery profile BP differentiated with respect to voltage. Alternatively, the differential profile DP may be considered a set of data pairs (dV/dQ, Q) and the control unit 120 may search the set for the data pair (dV/dQ, Q) having the smallest differential voltage (dV/dQ) value among the data pairs (dV/dQ, Q) having differential voltage (dV/dQ) values where the neighboring differential voltage (dV/dQ) values of the differential profile DP are both larger (or equal) to the respective differential voltage (dV/dQ) value in said data pairs. The control unit 120 may thus identify a global/absolute minimum of the differential voltage (dV/dQ) in the differential profile DP from a set of local minima of the differential profile DP, where the set of local minima may be determined by identifying the differential voltage (dV/dQ) values where the differential profile DP transitions from decreasing differential voltage (dV/dQ) values to increasing differential voltage (dV/dQ) values.

Specifically, the control unit 120 may be configured to determine a plurality of minimum points in the differential profile DP. A minimum point refers to a point in the differential profile that has an downward concave shape. For example, in the embodiment of FIG. 5, the differential profile DP may include first to fifth minimum points (p1, p2, p3, p4, p5). The plurality of minimum points in the differential profile DP may be also referred to a plurality of local minimum points or minima in the differential profile DP. The plurality of minimum points may be determined by the control unit 120 based on the differentiated differential profile. Alternatively, the differential profile DP may be considered a set of data pairs (dV/dQ, Q) and the control unit 120 may search the set for the data pairs (dV/dQ, Q) having a differential voltage (dV/dQ) value where the neighboring differential voltage (dV/dQ) values of the differential profile DP are both larger (or equal) to the differential voltage (dV/dQ) value so as to identify the differential voltage (dV/dQ) values where the differential profile DP transitions from decreasing differential voltage (dV/dQ) values to increasing differential voltage (dV/dQ) values.

As noted, the control unit 120 may be configured to determine the minimum point with the smallest corresponding differential voltage among the determined plurality of minimum points as the main peak (tp). For example, in the embodiment of FIG. 5, since the differential voltage corresponding to the third minimum point (p3) among the plurality of minimum points (p1, p2, p3, p4, p5) is the smallest, the control unit 120 may determine the third minimum point (p3) as the main peak (tp).

The control unit 120 may be configured to divide the capacity range of the battery based on the capacity of the determined main peak (tp). For example, in the embodiment of FIG. 5, if the capacity of the main peak (tp) is defined as the splitting point Qk, the control unit 120 may divide the capacity range into a first section R1 corresponding to the capacity range Qi to Qk and a second section R2 corresponding to the capacity range Qk to Qf as shown in FIG. 5.

Generally, based on the minimum point where the differential voltage is the smallest (which may also be denoted the global or absolute minimum point of the differential profile DP), the low capacity side reflects the state of the negative electrode of the battery, and the high capacity side reflects the state of the positive electrode of the battery. Therefore, the control unit 120 may divide the capacity range of the battery into sections not only based on a certain ratio (*n*: *m*) but also based on the main peak (tp) or alternatively based on the main peak (tp). In the latter case, the capacity value of the main peak (tp) may be set as Qk. In some embodiments, the control unit 120 may be configured to determine or calculate the ratio (*n*: *m*) based on the main peak (tp) of the differential profile DP, and to divide the capacity range of the battery profile BP based on the determined ratio (*n*: *m*)*.*

In another example, the control unit 120 may determine a minimum point that is included in a lower-middle capacity range of the battery and has the smallest corresponding differential voltage as the main peak (tp). The lower-middle capacity range may be a preset capacity sub-range of the capacity range Qi to Qf of the differential profile DP. The capacity sub-range may be a range from Qim to Qfm, where Qim ≥Qi and Qfm<Qf.

The capacity sub-range may be for example 50% of the capacity range from Qi to Qf, 55% of the capacity range from Qi to Qf, 60% of the capacity range from Qi to Qf, 65% of the capacity range from Qi to Qf (*Qf* - *Qi*)*,* 70% of the capacity range from Qi to Qf, 75% of the capacity range from Qi to Qf, or 80% of the capacity range from Qi to Qf. The capacity sub-range may start at Qim=Qi, Qim=Qi plus 5% of the capacity range from Qi to Qf, Qim=Qi plus 10% of the capacity range from Qi to Qf, Qim=Qi plus 15% of the capacity range from Qi to Qf, or Qim=Qi plus 20% of the capacity range from Qi to Qf. The combination of starting point Qim of the capacity sub-range and the total range from Qim to Qfm may be selected so that Qfm≤80% of Qf.

For example, the lower-middle capacity range of the battery may be a range from Qim = Qi to Qfm = Qim + 50% · (Qf - Qi); Qim = Qi to Qfm = Qim + 55% · (Qf - Qi); Qim = Qi to Qfm = Qim + 60% · (Qf - Qi); Qim = Qi to Qfm = Qim + 65% · (Qf - Qi); Qim = Qi to Qfm = Qim + 70% · (Qf - Qi); Qim = Qi to Qfm = Qim + 75% · (Qf - Qi); Qim = Qi + 5% · (Qf - Qi) to Qfm = Qim + 50% · (Qf - Qi); Qim = Qi + 5% · (Qf - Qi) to Qfm = Qim + 55% · (Qf - Qi); Qim = Qi + 5% · (Qf - Qi) to Qfm = Qim + 60% · (Qf - Qi); Qim = Qi + 5% · (Qf - Qi) to Qfm = Qim + 65% · (Qf - Qi); Qim = Qi + 5% · (Qf - Qi) to Qfm = Qim + 70% · (Qf - Qi); Qim = Qi + 5% . (Qf - Qi) to Qfm = Qim + 75% · (Qf - Qi); Qim = Qi + 10% · (Qf - Qi) to Qfm = Qim + 50% · (Qf - Qi); Qim = Qi + 10% · (Qf - Qi) to Qfm = Qim + 55%· (Qf - Qi); Qim = Qi + 10% · (Qf - Qi) to Qfm = Qim + 60% · (Qf - Qi); Qim = Qi + 10% · (Qf - Qi) to Qfm = Qim + 65% · (Qf - Qi); Qim = Qi + 10% · (Qf - Qi) to Qfm = Qim + 70% · (Qf - Qi); Qim = Qi + 10% · (Qf - Qi) to Qfm = Qim + 75%· (Qf - Qi); Qim = Qi + 15% · (Qf - Qi) to Qfm = Qim + 50% · (Qf - Qi); Qim = Qi + 15% · (Qf - Qi) to Qfm = Qim + 55% · (Qf - Qi); Qim = Qi + 15% · (Qf - Qi) to Qfm = Qim + 60% · (Qf - Qi); Qim = Qi + 15% · (Qf - Qi) to Qfm = Qim + 65%· (Qf - Qi); Qim = Qi + 15% · (Qf - Qi) to Qfm = Qim + 70% · (Qf - Qi); Qim = Qi + 20% · (Qf - Qi) to Qfm = Qim + 50% · (Qf - Qi); Qim = Qi + 20% · (Qf - Qi) to Qfm = Qim + 55% · (Qf - Qi); Qim = Qi + 20% · (Qf - Qi) to Qifm = Qim + 60%· (Qf - Qi); Qim = Qi + 20% · (Qf - Qi) to Qifm = Qim + 65% · (Qf - Qi); Qim = Qi + 20% · (Qf - Qi) to Qifm = Qim + 70% · (Qf - Qi); Qim = Qi + 25% · (Qf - Qi) to Qfm = Qim + 50% · (Qf - Qi) ; Qim = Qi + 25% · (Qf - Qi) to Qfm = Qim + 55%· (Qf - Qi); Qim = Qi + 25% · (Qf - Qi) to Qfm = Qim + 60% · (Qf - Qi); Qim = Qi + 25% · (Qf - Qi) to Qfm = Qim + 65% · (Qf - Qi).

In general, if the capacity range of a battery is divided into a low-capacity section and a high-capacity section, the minimum point with the smallest differential voltage may be commonly included in the low-capacity section. The low-capacity section may correspond to the capacity range Qi to Qk, and the high-capacity section may correspond to the capacity range Qk to Qf.

Alternatively, a splitting point Qlh may be preset approximately in the center of the capacity range Qi to Qf of the battery profile. The low-capacity section may correspond to the capacity range Qi to Qlh, and the high-capacity section may correspond to the capacity range Qlh to Qf. Qlh may be for example set as Qlh = Qi + 40% · (Qf - Qi), Qlh = Qi + 45%· (Qf - Qi), Qlh = Qi + 50% · (Qf - Qi), Qlh = Qi + 55% · (Qf - Qi), Qlh = Qi + 60% · (Qf - Qi)or Qlh = Qi + 65% · (Qf - Qi).

In some embodiments, the control unit 120 may determine the main peak (tp) in the low-capacity section (middle or lower capacity section) of the battery. That is, the control unit 120 may save time and system resources required to determine the main peak (tp) by determining the main peak (tp) among a plurality of minimum points included in the low-capacity section.

For example, in the embodiment of FIG. 5, the low-capacity section includes first to third minimum points (p1, p2, p3). The control unit 120 may determine the third minimum point (p3) with the smallest differential voltage among the first to third minimum points (p1, p2, p3) as the main peak (tp).

That is, since the total capacity range Qi to Qf and the low-capacity section have different numbers of minimum points, the time and system resources required to compare the differential voltage of the plurality of minimum points may also be different. Therefore, the control unit may determine the main peak more quickly by considering only the minimum points included in the low-capacity section.

In other embodiments, a differential profile obtained by the profile obtaining unit 110 may be configured to represent a correspondence relationship between the voltage V and the differential capacity dQ/dV of the battery.

The control unit 120 may be configured to determine a plurality of maximum points in the differential profile. The maximum point is a concept opposite to the minimum point, and refers to a point in the differential profile that has an upward convex shape.

In some embodiments, the control unit 120 may be configured to differentiate the differential profile DP with respect to capacity and to identify the main peak (tp) in the differentiated differential profile DP. The differentiated differential profile DP may be equivalent to a second derivative of the battery profile BP differentiated with respect to capacity. Alternatively, the differential profile DP may be considered a set of data pairs (dQ/dV, V) and the control unit 120 may search the set for the data pair (dQ/dV, V) having the smallest differential capacity (dQ/dV) value among the data pairs (dQ/dV, V) having differential capacity (dQ/dV) values where the neighboring differential capacity (dQ/dV) values of the differential profile DP are both smaller (or equal) to the respective differential capacity (dQ/dV) value in said data pairs. The control unit 120 may thus identify a global/absolute maximum of the differential capacity (dQ/dV) in the differential profile DP from a set of local maxima of the differential profile DP, where the set of local maxima may be determined by identifying the differential capacity (dQ/dV) values where the differential profile DP transitions from increasing differential capacity (dQ/dV) values to decreasing differential capacity (dQ/dV) values.

The plurality of maximum points in the differential profile DP may be also referred to a plurality of local maximum points or maxima in the differential profile DP. The plurality of maximum points may be determined by the control unit 120 based on the differentiated differential profile. Alternatively, the differential profile DP may be considered a set of data pairs (dQ/dV, V) and the control unit 120 may search the set for the data pairs (dQ/dV, V) having a differential capacity (dQ/dV) value where the neighboring differential capacity (dQ/dV) values of the differential profile DP are both smaller (or equal) to the differential capacity (dQ/dV) value so as to identify the differential capacity (dQ/dV) values where the differential profile DP transitions from increasing differential capacity (dQ/dV) values to decreasing differential capacity (dQ/dV) values.

In addition, the control unit 120 may be configured to determine a maximum point having the largest corresponding differential capacity among the determined plurality of maximum points as the main peak.

The apparatus 100 for diagnosing a battery according to the present disclosure may be applied to a battery management system (BMS). That is, the BMS according to the present disclosure may include the apparatus 100 for diagnosing a battery described above. In this configuration, at least some of components of the apparatus 100 for diagnosing a battery may be implemented by supplementing or adding functions of the components included in a conventional BMS. For example, the profile obtaining unit 110, the control unit 120 and the storage unit 130 of the apparatus 100 for diagnosing a battery may be implemented as components of the BMS.

Additionally, the apparatus 100 for diagnosing a battery according to the present disclosure may be provided in the battery pack. That is, the battery pack according to the present disclosure may include the above-described apparatus 100 for diagnosing a battery and at least one battery cell. Additionally, the battery pack may further include electrical components (relays, fuses, etc.) and a case.

FIG. 6 is a drawing schematically showing a battery pack 10 according to another embodiment of the present disclosure.

The positive electrode terminal of the battery 11 may be connected to the positive electrode terminal P+ of the battery pack 10, and the negative electrode terminal of the battery 11 may be connected to the negative electrode terminal P- of the battery pack 10.

The measuring unit 12 may be connected to the first sensing line SL1, the second sensing line SL2, and the third sensing line SL3. Specifically, the measuring unit 12 may be connected to the positive electrode terminal of the battery 11 through the first sensing line SL1 and connected to the negative electrode terminal of the battery 11 through the second sensing line SL2. The measuring unit 12 may measure the voltage of the battery 11 based on the voltage measured at each of the first sensing line SL1 and the second sensing line SL2.

Also, the measuring unit 12 may be connected to the current measuring unit A through the third sensing line SL3. For example, the current measuring unit A may be an ammeter or a shunt resistor capable of measuring the charging current and the discharging current of the battery 11. The measuring unit 12 may measure the charging current of the battery 11 through the third sensing line SL3 to calculate the charge amount. In addition, the measuring unit 12 may measure the discharging current of the battery 11 through the third sensing line SL3 to calculate the discharge amount.

For example, the profile obtaining unit 110 may receive battery information about the voltage and current of the battery from the measuring unit 12. Then, the profile obtaining unit 110 may generate a battery profile BP and a differential profile based on the battery information.

As another example, the profile obtaining unit 110 may receive the battery profile BP from the measuring unit 12. Then, the profile obtaining unit 110 may generate a differential profile based on the battery profile BP.

As still another example, the profile obtaining unit 110 may receive a differential profile from the measuring unit 12.

An external device may be connected to the positive electrode terminal P+ and the negative electrode terminal P- of the battery pack 10. For example, the external device may be a charging device or a load. In addition, the positive electrode terminal of the battery 11, the positive electrode terminal P+ of the battery pack 10, the external device, the negative electrode terminal P- of the battery pack 10, and the negative electrode terminal of the battery 11 may be electrically connected.

FIG. 7 is a drawing schematically showing a vehicle 700 according to still another embodiment of the present disclosure.

Referring to FIG. 7, the battery pack 710 according to the embodiment of the present disclosure may be included in a vehicle 700, such as an electric vehicle (EV) or a hybrid vehicle (HV). In addition, the battery pack 710 may drive the vehicle 700 by supplying power to a motor through an inverter provided in the vehicle 700. Here, the battery pack 710 may include the apparatus 100 for diagnosing a battery. That is, the vehicle 700 may include the apparatus 100 for diagnosing a battery. In this case, the apparatus 100 for diagnosing a battery may be an onboard device included in the vehicle 700.

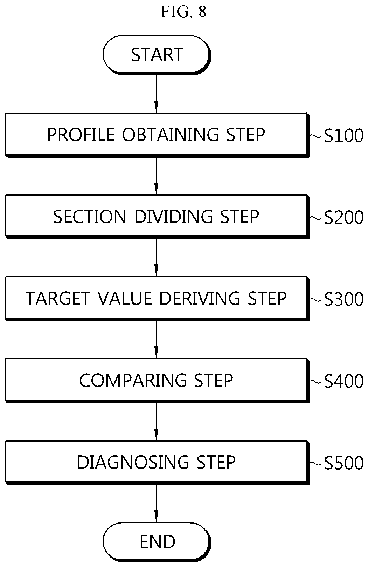

FIG. 8 is a diagram schematically showing a method for diagnosing a battery according to still another embodiment of the present disclosure.

Referring to FIG. 8, the method for diagnosing a battery may include a profile obtaining step (S100), a section dividing step (S200), a target value deriving step (S300), a comparing step (S400), and a diagnosing step (S500).

Preferably, each step of the method for diagnosing a battery may be performed by the apparatus 100 for diagnosing a battery. Hereinafter, for convenience of explanation, content that overlaps with the content described above will be omitted or briefly described.

The profile obtaining step (S100) is a step of obtaining a battery profile BP representing a correspondence relationship between voltage and capacity of a battery. The profile obtaining step (S100) may be performed by the profile obtaining unit 110.

For example, the profile obtaining unit 110 may directly receive the battery profile BP of the battery from the outside. That is, the profile obtaining unit 110 may obtain the battery profile BP by being connected to the outside via wire and/or wirelessly and receiving the battery profile BP.

As another example, the profile obtaining unit 110 may receive battery information about the voltage and capacity of the battery. Then, the profile obtaining unit 110 may generate a battery profile BP based on the received battery information. That is, the profile obtaining unit 110 may obtain the battery profile BP by directly generating the battery profile BP based on the battery information.

The section dividing step (S200) is a step of dividing a capacity range of the battery profile BP into a plurality of sections. The section dividing step (S200) may be performed by the control unit 120.

Specifically, the control unit 120 may divide the entire capacity range of the battery profile BP into two or more sections. For example, in the embodiment of FIG. 2, the capacity range of the battery profile BP are Qi to Qf. The control unit 120 may divide the capacity range of Qi to Qf into the first section R1 and the second section R2 based on Qk.

The target value deriving step (S300) is a step of deriving a target value for any one of one or more target indicators among a plurality of diagnostic indicators preset in each section. The target value deriving step (S300) may be performed by the control unit 120.

For example, in the embodiment of FIG. 3, the control unit 120 may select a target indicator for each of the first section R1 and the second section R2. Then, control unit 120 may derive a target value corresponding to the selected target indicator. It is also possible that the control unit 120 selects more than one target indicator for each of the first section R1 and the second section R2. Then, control unit 120 may derive respective target values corresponding to each of the selected target indicator for the regions R1 and R2.

The comparing step (S400) is a step of comparing the correspondence relationship between the derived plurality of target values with one or more reference profiles preset to indicate the correspondence relationship between the plurality of target indicators. The comparing step (S400) may be performed by the control unit 120.

In one example, it is assumed that the capacity range of the battery profile BP is divided into the first section R1 and the second section R2, the first target value for the target indicator is derived from the first section R1, and the second target value for the target indicator is derived from the second section R2. The control unit 120 may compare the target point representing the correspondence relationship of the plurality of target values with a reference profile.

For example, in the embodiment of FIG. 4, the control unit 120 may determine whether the target point is included in the reference profile. If the target point is not included in the reference profile, the control unit 120 may determine which region among the first region T1, the second region T2, and the third region T3 the target point is included in.

The diagnosing step (S500) is a step for diagnosing a state of the battery based on the comparison result. The diagnosing step (S500) may be performed by the control unit 120.

For example, in the embodiment of FIG. 4, the control unit 120 may diagnose the state of the battery as a positive/negative electrode degradation state if the target point is included in the reference profile.

As another example, the control unit 120 may diagnose the state of the battery as a negative electrode degradation state if the target point is included in the first region T1.

As still another example, the control unit 120 may diagnose the state of the battery as a positive electrode degradation state if the target point is included in the second region T2.

As still another example, the control unit 120 may diagnose the state of the battery as EOL state if the target point is included in third region T3.

The embodiments of the present disclosure described above may not be implemented only through an apparatus and a method, but may be implemented through a program that realizes a function corresponding to the configuration of the embodiments of the present disclosure or a recording medium on which the program is recorded. The program or recording medium may be easily implemented by those skilled in the art from the above description of the embodiments.

The present disclosure has been described in detail. However, it should be understood that the detailed description and specific examples, while indicating preferred embodiments of the disclosure, are given by way of illustration only, since various changes and modifications within the scope of the disclosure will become apparent to those skilled in the art from this detailed description.

Additionally, many substitutions, modifications and changes may be made to the present disclosure described hereinabove by those skilled in the art without departing from the technical aspects of the present disclosure, and the present disclosure is not limited to the above-described embodiments and the accompanying drawings, and each embodiment may be selectively combined in part or in whole to allow various modifications.

### (Explanation of reference signs)

- 10:: battery pack
- 11:: battery
- 12:: measuring unit
- 100:: apparatus for diagnosing a battery
- 110:: profile obtaining unit
- 120:: control unit
- 130:: storage unit
- 700:: vehicle
- 710:: battery pack

## Claims

1. An apparatus for diagnosing a battery, comprising:
a profile obtaining unit configured to obtain a battery profile representing a correspondence relationship between voltage and capacity of a battery; and
a control unit configured to:
divide a capacity range of the battery profile into a plurality of sections,
derive a target value for any one target indicator among a plurality of diagnostic indicators preset in each section,
compare a correspondence relationship between the derived plurality of target values with one or more reference profiles preset to represent a correspondence relationship between the plurality of target indicators, and
diagnose a state of the battery based on the comparison result.

2. The apparatus for diagnosing a battery according to claim 1,
wherein the control unit is configured to:
diagnose the state of the battery as a positive/negative electrode degradation state when a target point representing the correspondence relationship between the plurality of target values is included in the reference profile,
diagnose the state of the battery as a negative electrode degradation state when the target point is included in a first region based on the reference profile, and
diagnose the state of the battery as a positive electrode degradation state when the target point is included in a second region based on the reference profile.

3. The apparatus for diagnosing a battery according to claim 2,
wherein the control unit is configured to diagnose the state of the battery as an EOL state when the target point is included in a third region, and
wherein the third region is configured to be preset as a region that exceeds a preset threshold value for each of the plurality of target indicators.

4. The apparatus for diagnosing a battery according to claim 2,
wherein the control unit is configured to reduce at least one of an upper limit C-rate and a constant voltage charge time set for the battery when the state of the battery is diagnosed as the positive electrode degradation state or the positive/negative electrode degradation state.

5. The apparatus for diagnosing a battery according to claim 2,
wherein the control unit is configured to reduce a charge upper limit voltage set for the battery when the state of the battery is diagnosed as the negative electrode degradation state or the positive/negative electrode degradation state.

6. The apparatus for diagnosing a battery according to claim 1,
wherein the control unit is configured to divide the capacity range into a first section and a second section based on a preset division ratio or target capacity.

7. The apparatus for diagnosing a battery according to claim 6,
wherein the profile obtaining unit is configured to obtain a differential profile corresponding to the battery profile, and
wherein the control unit is configured to determine a main peak from the differential profile and divide the capacity range based on a capacity of the determined main peak.

8. The apparatus for diagnosing a battery according to claim 7,
wherein the differential profile is configured to represent a correspondence relationship between the capacity and a differential voltage of the battery, and
wherein the control unit is configured to determine a plurality of minimum points in the differential profile, and determine a minimum point with the smallest corresponding differential voltage as a main peak among the determined plurality of minimum points.

9. The apparatus for diagnosing a battery according to claim 7,
wherein the differential profile is configured to represent a correspondence relationship between the voltage and a differential capacity of the battery, and
wherein the control unit is configured to determine a plurality of maximum points in the differential profile, and determine a maximum point with the largest corresponding differential voltage as a main peak among the determined plurality of maximum points.

10. A battery pack, comprising the apparatus for diagnosing a battery according to any one of claims 1 to 9.

11. A vehicle, comprising the apparatus for diagnosing a battery according to any one of claims 1 to 9.

12. A method for diagnosing a battery, comprising:
a profile obtaining step of obtaining a battery profile representing a correspondence relationship between voltage and capacity of a battery;
a section dividing step of dividing a capacity range of the battery profile into a plurality of sections;
a target value deriving step of deriving a target value for any one of one or more target indicators among a plurality of diagnostic indicators preset in each section;
a comparing step of comparing a correspondence relationship between the derived plurality of target values with one or more reference profiles preset to represent a correspondence relationship between the plurality of target indicators; and
a diagnosing step of diagnosing a state of the battery based on the comparison result.
